(19) **Europäisches Patentamt**

**European Patent Office**

**Office européen des brevets**

(11) **EP 1 684 336 A1**

(12) **EUROPEAN PATENT APPLICATION**
published in accordance with Art. 158(3) EPC

(43) Date of publication:
**26.07.2006 Bulletin 2006/30**

(51) Int Cl.:
*H01L 21/205* (2006.01)  *H01L 21/31* (2006.01)
*H01L 21/324* (2006.01)  *C23C 16/44* (2006.01)
*H01L 21/22* (2006.01)  *H01L 21/223* (2006.01)
*H01L 21/225* (2006.01)  *H01L 21/228* (2006.01)

(21) Application number: **04799419.9**

(22) Date of filing: **01.11.2004**

(86) International application number:
**PCT/JP2004/016213**

(87) International publication number:
**WO 2005/043609 (12.05.2005 Gazette 2005/19)**

(84) Designated Contracting States:
**DE FR GB IT NL**

(30) Priority: **30.10.2003 JP 2003371291**
**20.10.2004 JP 2004306040**

(71) Applicant: **TOKYO ELECTRON LIMITED**
**Minato-ku,**
**Tokyo 107-8481 (JP)**

(72) Inventors:
• **PARK, Y.,**
**Tokyo Electron Ltd,**
**Tokyo 1078481 (JP)**

• **KAWAMURA, K.,**
**Tokyo Electron Ltd**
**Tokyo 1078481 (JP)**
• **WANG, W.,**
**Tokyo Electron Ltd**
**Tokyo 1078481 (JP)**

(74) Representative: **Liesegang, Eva**
**Forrester & Boehmert,**
**Pettenkoferstrasse 20-22**
**80336 München (DE)**

(54) **HEAT TREATMENT APPARATUS AND HEAT TREATMENT METHOD**

(57) The thermal processing apparatus of the present invention includes: a processing container for containing an object to be processed; a plurality of heaters for heating the object to be processed; a plurality of temperature sensors for respectively detecting temperatures at a plurality of predetermined positions in the processing container; a storing part that stores: a thermal model for forecasting a temperature of the object to be processed contained in the processing container from outputs of the plurality of temperature sensors, and a recipe in which a desired temperature of the object to be processed is defined; and a controlling part that forecasts a temperature of the object to be processed by using the outputs of the plurality of temperature sensors and the thermal model, and that controls the plurality of heaters so as to cause the forecasted temperature of the object to be processed to coincide with the desired temperature of the object to be processed defined in the recipe. The thermal model is configured to forecast, from the outputs of the plurality of temperature sensors, not only a temperature of the object to be processed contained in the processing container but also a temperature of at least one other predetermined portion in the processing container. A desired temperature of the predetermined portion is also defined in the recipe. The controlling part is adapted to forecast a temperature of the object to be processed and a temperature of the predetermined portion by using the outputs of the plurality of temperature sensors and the thermal model, and to control the plurality of heaters so as to cause the forecasted temperature of the object to be processed and the forecasted temperature of the predetermined portion to respectively coincide with the desired temperature of the object to be processed and the desired temperature of the predetermined portion defined in the recipe.

FIG. 1

**Description**

Field of the Invention

This invention relates to a thermal processing apparatus that conducts a thermal process to an object to be processed, such as a semiconductor wafer. In particular, this invention relates to a thermal processing apparatus and a thermal processing method wherein a temperature of an object to be processed is forecasted by using a thermal model and wherein a thermal process is conducted based on the forecasted result.

Background Art

As a batch-type of thermal processing apparatus that can conduct a thermal process such as a film-forming process, an oxidation process and a diffusion process, to a plurality of objects to be processed at one time, there are known a horizontal type of thermal processing apparatus and a vertical type of thermal processing apparatus. Recently, the vertical type of thermal processing apparatus has been predominant because it causes less air involution.

The thermal processing apparatus conducts a thermal process while controlling process conditions such as a process temperature, a process pressure and a gas flow rate to coincide with target values defined in a recipe. Thus, in order to conduct the thermal process properly, it is necessary to measure a temperature of a wafer, a pressure in a reaction furnace, a gas flow rate, and so on.

The pressure in a reaction furnace may be measured relatively accurately by means of a pressure gage. In addition, the gas flow rate may be measured relatively accurately by means of a mass-flow controller including a flowmeter arranged in a supplying pipe. However, it is difficult to measure the temperature of a wafer. A method of attaching a temperature sensor to a wafer has been proposed. However, in the method, a semiconductor device can not be formed at the position where the temperature sensor has been attached. In addition, impurities from the temperature sensor may pollute the whole reaction furnace, which may cause deterioration of yield of the semiconductor device.

Conventional techniques to solve the above problem have been disclosed in JP Laid-Open Publication No. 2002-25997 and in USP 5,517,594, for example. In these techniques, a plurality of temperature sensors is arranged in a reaction furnace, a temperature of a wafer is forecasted by the minute based on a thermal model (a mathematical model) relating to outputs of the plurality of temperature sensors and electric power supply to a heater for heating the reaction furnace, and the electric power supply to the heater is controlled by using the forecasted value. According to the techniques, the temperature of a wafer can be forecasted relatively accurately in a noncontact manner, and the thermal processing apparatus can be suitably controlled based on the forecasted value.

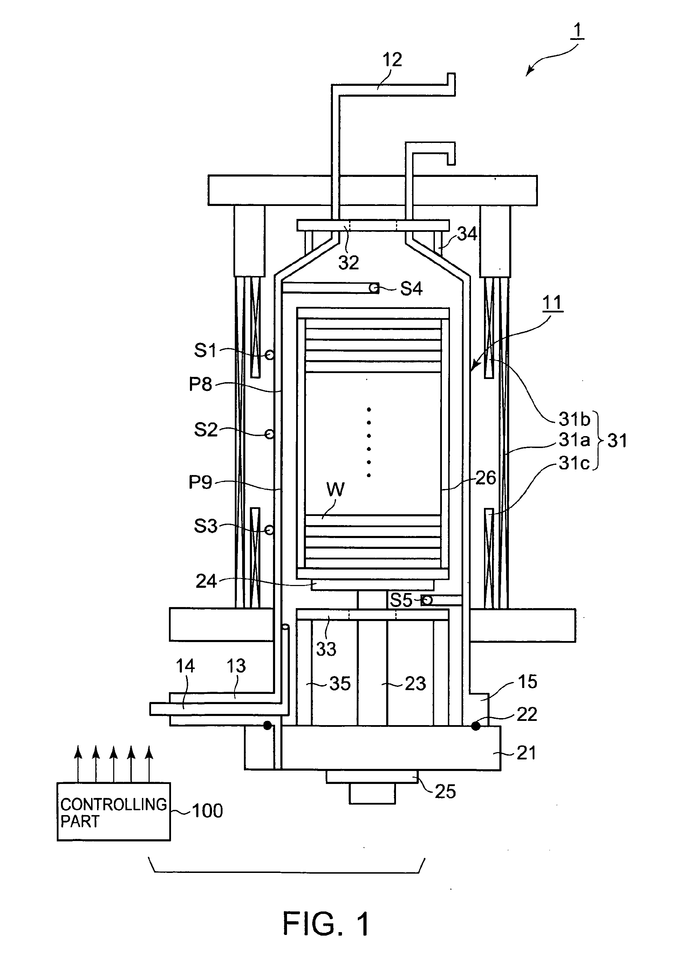

Conventionally, in the above type of thermal processing apparatus, as shown in Fig. 1 of JP Laid-Open Publication No. 2002-25997, the heater is generally provided at a side wall of the reaction tube (reaction furnace) in order to secure uniformity of temperature in a vertical direction in the processing container.

Recently, many-kinds and small-amount production has been requested increasingly. Accordingly, a batch type of vertical thermal processing apparatus having a small processing container (that processes a relatively small number of wafers) has been proposed. On the other hand, the wafer as an object to be processed has been enlarged increasingly. Thus, a ratio of a diameter R with respect to a height T of the processing container has been increased.

In the above design, there is a problem that it is difficult to secure the uniformity of temperature in a vertical direction in the processing container. In order to solve the problem, a batch type of vertical thermal processing apparatus has been developed wherein planar heaters (upper heater and lower heater) are provided at upper and lower portions in the processing container.

Summary of the Invention

However, in such a thermal processing apparatus, regarding wafers W arranged at upper-end and lower-end portions of a wafer boat, temperature difference within a surface and temperature difference between surfaces may be caused depending on how to control the upper heater and the lower heater, so that film-thickness and film-quality may not be made uniform.

In addition, in such a thermal processing apparatus, inside temperature of the processing container changes sharply when the wafer boat is loaded in the processing container and when the wafer boat is unloaded from the processing container. Thus, reaction products adhering on an inside surface of the processing container as a layer may be peeled off, so that so-called particles may be generated. The particles may adhere on a wafer W to be processed, to have adverse effect on the subsequent process.

These problems are common in any type of thermal processing apparatus that processes various objects to be processed, not limited to the semiconductor wafer.

This invention is intended to solve the above problems. The object of this invention is to provide a thermal processing apparatus and a thermal processing method that can conduct a temperature control more properly.

In addition, the object of this invention is to provide a thermal processing apparatus and a thermal processing method wherein heaters are provided at a side portion, an upper portion and a lower portion with respect to an object to be processed, wherein a temperature of the object to be processed is forecasted by using a thermal model, wherein a thermal process is conducted based on the forecasted temperature, and wherein a temperature control can be conducted more properly.

In addition, the object of this invention is to provide a thermal processing apparatus and a thermal processing method that can inhibit particle generation.

The invention is a thermal processing apparatus comprising: a processing container for containing an object to be processed; a plurality of heaters for heating the object to be processed; a plurality of temperature sensors for respectively detecting temperatures at a plurality of predetermined positions in the processing container; a storing part that stores: a thermal model for forecasting a temperature of the object to be processed contained in the processing container from outputs of the plurality of temperature sensors, and a recipe in which a desired temperature of the object to be processed is defined; and a controlling part that forecasts a temperature of the object to be processed by using the outputs of the plurality of temperature sensors and the thermal model, and that controls the plurality of heaters so as to cause the forecasted temperature of the object to be processed to coincide with the desired temperature of the object to be processed defined in the recipe; wherein the thermal model is configured to forecast, from the outputs of the plurality of temperature sensors, not only a temperature of the object to be processed contained in the processing container but also a temperature of at least one other predetermined portion in the processing container; a desired temperature of the predetermined portion is also defined in the recipe; and the controlling part is adapted to forecast a temperature of the object to be processed and a temperature of the predetermined portion by using the outputs of the plurality of temperature sensors and the thermal model, and to control the plurality of heaters so as to cause the forecasted temperature of the object to be processed and the forecasted temperature of the predetermined portion to respectively coincide with the desired temperature of the object to be processed and the desired temperature of the predetermined portion defined in the recipe.

According to the above feature, since the temperature of the predetermined portion other than the object to be processed is also a control object (target), the temperature control in the processing container can be conducted more properly, compared with the case

wherein only the temperature of the object to be processed is a control object (target). Thus, particle generation can be inhibited.

For example, when an inside heater is arranged in the processing container as one of the plurality of heaters, the at least one other predetermined portion in the processing container may include the inside heater in the processing container.

Alternatively, the at least one other predetermined portion in the processing container may include a predetermined portion of an inside wall surface of the processing container.

Alternatively, when an upper heater and a lower heater are arranged correspondingly to an upper portion and a lower portion of the object to be processed contained in the processing container as two of the plurality of heaters, the at least one other predetermined portion in the processing container may include the upper heater and the lower heater.

In the case, preferably, a gas-discharging pipe is connected to an upper portion of the processing container, and the upper heater is arranged so as to surround the gas-discharging pipe.

Alternatively, when an upper heater and a lower heater are arranged correspondingly to an upper portion and a lower portion of the object to be processed contained in the processing container as two of the plurality of heaters, and an upper temperature sensor is arranged between the object to be processed contained in the processing container and the upper heater as one of the plurality of temperature sensors, the at least one other predetermined portion in the processing container may include the upper temperature sensor and the lower heater.

In the case too, preferably, a gas-discharging pipe is connected to an upper portion of the processing container, and the upper heater is arranged so as to surround the gas-discharging pipe.

In addition, when the thermal processing apparatus further comprises: a unit of introducing a gas to a gas-introducing port of the processing container, and a unit of discharging the gas from a gas-discharging port of the processing container, it is preferable that the at least one other predetermined portion in the processing container is set between the gas-introducing port and a portion on the most downstream side of the object to be processed, along a path from the gas-introducing port to the gas-discharging port.

In addition, it is preferable that: the thermal model is configured to forecast, from the outputs of the plurality of temperature sensors during a thermal process, a temperature of the object to be processed contained in the processing container during the thermal process and a temperature of the at least one other predetermined portion in the processing container during the thermal process; a desired temperature of the object to be processed during the thermal process and a desired temperature of the predetermined portion during the thermal process are defined in the recipe; and the controlling part is adapted to forecast a temperature of the object to be processed during the thermal process and a temperature of the predetermined portion during the thermal process by using the outputs of the plurality of temperature sensors and the thermal model, and to control the plurality of heaters so as to cause the forecasted temperature of the object to be processed and the forecasted temperature of the predetermined portion to respectively coincide with the desired temperature of the object to be processed during the thermal process and the desired temperature of the predetermined portion during the thermal process defined in the recipe.

Furthermore, when the thermal processing apparatus further comprises a loading/unloading unit that loads an object to be processed into the processing container and, that unloads the object to be processed from the processing container after a thermal process, it is preferable that: the thermal model is configured to forecast, from the outputs of the plurality of temperature sensors during a loading and/or unloading process, a temperature of the object to be processed contained in the processing container during the loading and/or unloading process and a temperature of the at least one other predetermined portion in the processing container during the loading and/or unloading process; a desired temperature of the object to be processed during the loading and/or unloading process and a desired temperature of the predetermined portion during the loading and/or unloading process are defined in the recipe; and the controlling part is adapted to forecast a temperature of the object to be processed during the loading and/or unloading process and a temperature of the predetermined portion during the loading and/or unloading process by using the outputs of the plurality of temperature sensors and the thermal model, and to control the plurality of heaters so as to cause the forecasted temperature of the object to be processed and the forecasted temperature of the predetermined portion to respectively coincide with the desired temperature of the object to be processed during the loading and/or unloading process and the desired temperature of the predetermined portion during the loading and/or unloading process defined in the recipe.

In addition, the present invention is a thermal processing method of controlling a thermal processing apparatus including: a processing container for containing an object to be processed; a plurality of heaters for heating the object to be processed; and a plurality of temperature sensors for respectively detecting temperatures at a plurality of predetermined positions in the processing container; the thermal processing method comprising: a forecasting step of forecasting a temperature of the object to be processed and a temperature of at least one other predetermined portion in the processing container by applying outputs of the plurality of temperature sensors to a thermal model that has been set in advance; and a controlling step of controlling the plurality of heaters so as to cause the forecasted temperature of the object to be processed and the forecasted temperature of the predetermined portion to respectively coincide with a desired temperature of the object to be processed and a desired temperature of the predetermined portion that have been defined in advance.

Alternatively, the present invention is a program for controlling a thermal processing apparatus including: a processing container for containing an object to be processed; a plurality of heaters for heating the object to be processed; and a plurality of temperature sensors for respectively detecting temperatures at a plurality of predetermined positions in the processing container; the program being adapted to cause a computer to execute: a forecasting step of forecasting a temperature of the object to be processed and a temperature of at least one other predetermined portion in the processing container by applying outputs of the plurality of temperature sensors to a thermal model that has been set in advance; and a controlling step of controlling the plurality of heaters so as to cause the forecasted temperature of the object to be processed and the forecasted temperature of the predetermined portion to respectively coincide with a desired temperature of the object to be processed and a desired temperature of the predetermined portion that have been defined in advance.

Alternatively, the present invention is a storage medium capable of being read by a computer, storing a program for controlling a thermal processing apparatus including: a processing container for containing an object to be processed; a plurality of heaters for heating the object to be processed; and a plurality of temperature sensors for respectively detecting temperatures at a plurality of predetermined positions in the processing container; the program being adapted to cause a computer to execute: a forecasting step of forecasting a temperature of the object to be processed and a temperature of at least one other predetermined portion in the processing container by applying outputs of the plurality of temperature sensors to a thermal model that has been set in advance; and a controlling step of controlling the plurality of heaters so as to cause the forecasted temperature of the object to be processed and the forecasted temperature of the predetermined portion to respectively coincide with a desired temperature of the object to be processed and a desired temperature of the predetermined portion that have been defined in advance.

Alternatively, the present invention is a controlling unit for controlling a thermal processing apparatus including: a processing container for containing an object to be processed; a plurality of heaters for heating the object to be processed; and a plurality of temperature sensors for respectively detecting temperatures at a plurality of predetermined positions in the processing container; the controlling unit comprising: a storing part that stores: a thermal model for forecasting a temperature of the object to be processed contained in the processing container from outputs of the plurality of temperature sensors, and a recipe in which a desired temperature of the object to be processed is defined; and a controlling part that forecasts a temperature of the object to be processed by using the outputs of the plurality of temperature sensors and the.thermal model, and that controls the plurality of heaters so as to cause the forecasted temperature of the object to be processed to coincide with the desired temperature of the object to be processed defined in the recipe; wherein the thermal model is configured to forecast, from the outputs of the plurality of temperature sensors, not only a temperature of the object to be processed contained in the processing container but also a temperature of at least one other predetermined portion in the processing container; a desired temperature of the predetermined portion is also defined in the recipe; and the controlling part is adapted to forecast a temperature of the object to be processed and a temperature of the predetermined portion by using the outputs of the plurality of temperature sensors and the thermal model, and to control the plurality of heaters so as to cause the forecasted temperature of the object to be processed and the forecasted temperature of the predetermined portion to respectively coincide with the desired temperature of the object to be processed and the desired temperature of the predetermined portion defined in the recipe.

The controlling unit or any element of the controlling unit can be materialized by a computer system. A program for materializing the controlling unit or any element of the controlling unit in a computer system, and a storage medium storing the program and capable of being read by a computer, are also intended to be protected by this application.

In addition, when the above controlling unit or any element of the above controlling unit may be materialized in a computer system by using a general program such as an OS, a program including a command or commands for controlling the general program, and a storage medium storing the program and capable of being read by a computer, are also intended to be protected by this application.

Herein, the storage medium may be not only a tangible object such as a floppy disk or the like, but also a network for transmitting various signals.

Brief Description of the Drawings

Fig. 1 is a schematic sectional view showing a structure of a thermal processing apparatus according to an embodiment of the present invention;
Fig. 2 is schematic view showing a structure of the controlling part of the thermal processing apparatus of Fig. 1;
Fig. 3A is a view showing an example of data stored in the thermal-model storing part of Fig. 2;
Fig. 3B is a view showing an example of data stored in the recipe storing part of Fig. 2;
Fig. 4 is a perspective view for explaining a temperature measurement position of a lower heater;
Fig. 5 is a graph showing an example of set-up recipe;
Fig. 6 is a graph showing an example of process recipe;
Fig. 7 is a schematic view showing an example of structure of a temperature measuring apparatus;
Fig. 8 is a schematic vertical sectional view showing a state wherein arm portions of the temperature measuring apparatus are inserted into a boat;
Fig. 9 is a flow chart for explaining procedures for correcting a standard thermal model to generate a corrected thermal model,
Fig. 10 is a stored table associating temperatures forecasted by the standard thermal model with temperatures measured actually, regarding respective set temperatures in the set-up recipe,
Fig. 11 is a graph for explaining a correction amount from the standard thermal model;
Fig. 12A is a flow chart showing procedures for a loading operation;
Fig. 12B is a flow chart showing procedures for an unloading operation; and
Fig. 13 is a flow chart for explaining an example of film-forming process.

Description of the Preferred Embodiment

Hereinafter, embodiments of the present invention are explained in detail with reference to the attached drawings.

A vertical type of thermal processing apparatus 1 of the present embodiment comprises a processing container (reaction tube) 11, as shown in Fig. 1. The processing container 11 is adapted to contain wafers W as objects to be processed, and to conduct a predetermined thermal process, such as a CVD process, to the wafers W. The processing container 11 is made of a material having heat resistance and corrosion resistance, such as a quartz glass. The processing container 11 has a single tube structure, in which upper and lower ends thereof are opened. The upper end portion is narrowed into a thin diameter in order to form a gas-discharging portion 12. The gas-discharging portion 12 is connected to a vacuum pump and so on, via a gas-discharging pipe not shown and the like.

A gas-introducing part (gas-introducing port) 13 for introducing a process gas and/or an inert gas into the processing container 11 is arranged at a lower portion of the processing container 11. A plurality of gas-supplying pipes 14 communicated with a gas source is inserted through the gas-introducing part 13. The process gas introduced through the gas-introducing part 13 goes up in the processing container 11, is used for the predetermined thermal process to the wafers W, and is discharged from the gas-discharging part 12.

A lower end portion of the processing container 11 is formed into a flange. The lower end portion 15 is opened and closed by a lid 21, which is made of a material having heat resistance and corrosion resistance such as stainless steel. The lid 21 is moved up and down by an elevator not shown. The lid 21 hermetically closes the lower end portion 15 of the processing container 11 at a moved-up position thereof, and opens the same at a moved-down position thereof.

An O-ring 22 for securing airtightness is arranged between the lower end portion 15 of the processing container 11 and the lid 21.

A rotation column 23 stands up at a central portion of the lid 21 in a rotatable manner. A rotation table 24 is fixed to an upper end of the rotation column 23.

A driving part 25 that causes the rotation column 23 to rotate is provided at a lower portion of the lid 21.

A boat (wafer boat) 26 made of a quartz glass and capable of holding for example 60 semiconductor wafers W at predetermined intervals in a vertical direction is placed on the rotation table 24. The boat 26 is placed on the rotation table 24 under a condition wherein the lid 21 is moved down. Then, the lid 21 is moved up, and hermetically closes the lower end portion 15 of the processing container 11, so that the loading operation of the boat 26 into the processing container 11 is completed. After a thermal process is completed, the lid 21 is moved down, and the boat 26 is unloaded. During the thermal process, the rotation table 24 is caused to rotate by the driving part 25, so that the wafers W are thermally processed uniformly.

A circumferential heater 31 for heating the wafers W contained in the processing container 11 from peripheral portions thereof is arranged around the processing container 11. The circumferential heater 31 is arranged in a vertical cylindrical shape so as to surround the processing container 11. The circumferential heater 31 is formed by a plurality of rod-like resistance heating members, for example. The circumferential heater 31 of the present embodiment consists of: main heaters 31a that heat the whole circumferential surface of the processing container 11; upper-end sub-heaters 31b that heat a circumferential surface on the upper-end side of the processing container 11, and lower-end sub-heaters 31c that heat a circumferential surface on the lower-end side of the processing container 11. The main heaters 31a and the sub-heaters 31b, 31c are arranged alternately in a circumferential direction of the processing container 11.

An upper heater 32 is provided at an upper portion of the processing container 11.

The upper heater 32 is formed in a doughnut shape around the gas-discharging pipe 12, and fixed to the processing container 11 by means of a supporting member 34. Thus, the upper heater 32 prevents temperature fall of the wafers W, which may be caused by heat radiation from the gas-discharging portion 12 of the processing container 11.

A lower heater 33 is provided at a lower portion of the processing container 11.

The lower heater 33 is arranged under the rotation table 24 in the processing container 11, and fixed to the lid 21 by means of a supporting member 35. The lower heater 33 is formed in a doughnut shape in such a manner that the rotation column 23 pierces through a central portion thereof. Thus, the lower heater 33 prevents temperature fall of the wafers W, which may be caused by heat radiation from the lid 21 or the like.

Three temperature sensors S1 to S3 are arranged in a vertical direction on the outside surface of the processing container 11. The temperature sensor S1 is arranged at a position corresponding to an upper portion of the boat 26, the temperature sensor S2 is arranged at a position corresponding to a central portion of the boat 26, and the temperature sensor S3 is arranged at a position corresponding to a lower portion of the boat 26.

In addition, a temperature sensor S4 is arranged between the upper heater 32 in the processing container 11 and the upper end surface of the boat 25. In addition, a temperature sensor S5 is arranged between the lower heater 33 in the processing container 11 and the rotation table 24. Each temperature sensor S4, S5 is contained in a quartz tube, for example, in order to prevent generation of metal contamination in the processing container 11.

Outputs (detected temperatures) of the temperature sensors S1 to S5 are used to forecast (estimate, predict) respective surface temperatures: of the wafers W placed on the boat 26, of the upper heater 32, and of the lower heater 33.

The thermal processing apparatus 1 comprises a controlling part 100 that controls the whole apparatus.

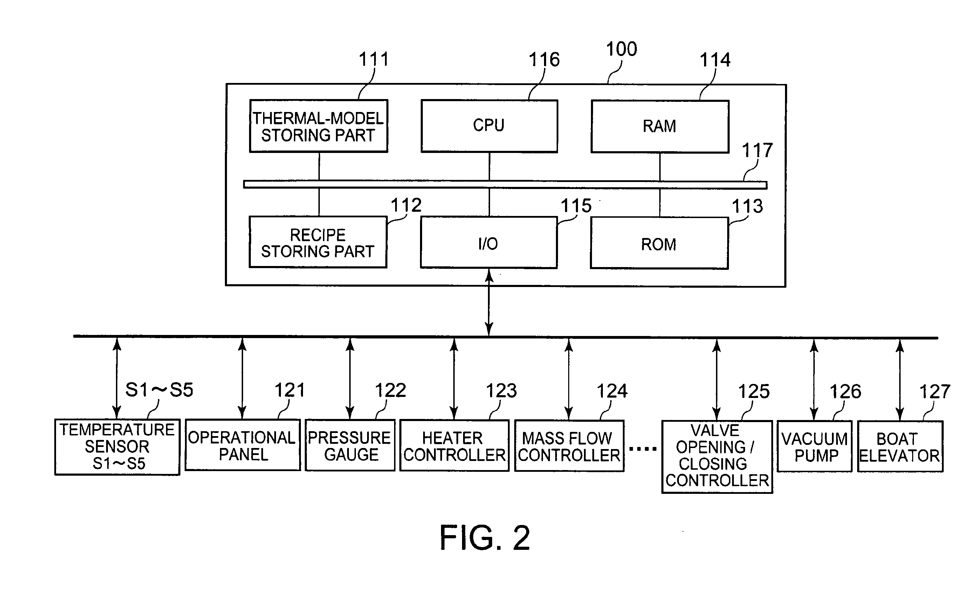

As shown in Fig. 2, the controlling part 100 is connected to the temperature sensors S1 to S5, an operational panel 121, a pressure gauge(s) 122, a heater controller 123, a massflow controller 124, a valve opening/closing controller 125, a vacuum pump 126, a boat elevator 127, and the like.

The temperature sensors S1 to S3 measure temperatures at the outside wall of the processing container 11, and inform the controlling part 100 of them. The temperature sensor S4 measures a temperature in the vicinity of the upper heater 32, and informs the controlling part 100 of it. The temperature sensor S5 measures a temperature in the vicinity of the lower heater 33, and informs the controlling part 100 of it.

The operational panel 121 comprises a display screen and operational buttons. Through the operational buttons, operations and/or instructions from an operator are transmitted to the controlling part 100. In addition, various information from the controlling part 100 is displayed on the display screen.

The pressure gauge(s) 122 measure pressures at respective positions in the processing container 11 and in the gas-discharging portion 12, and inform the controlling part 100 of them.

The heater controller 123 controls the heaters 31a, 31b, 31c, 32 and 33, independently. Concretely, in response to instructions from the controlling part 100, the heater controller 123 supplies electric power to the heaters 31a, 31b, 31c, 32 and 33, in order to heat them. In addition, the heater controller 123 measures electric power consumption of the heaters 31a, 31b, 31c, 32 and 33, independently, and informs the controlling part 100 of the measured values.

The massflow controller 124 is arranged for each pipe, and controls a flow rate of a gas flowing in each pipe to a value instructed by the controlling part 100. In addition, the massflow controller 124 measures a flow rate of the gas that actually flows, and informs the controlling part 100 of the measured value.

The valve opening/closing controller 125 is arranged for each pipe, and controls an opening degree of a valve arranged in each pipe to a value instructed by the controlling part 100.

The vacuum pump 126 is connected to the gas-discharging pipe 12 of the processing container 11 via a gas-discharging pipe or the like, and discharges the gas from the processing container 11.

The boat elevator 127 moves up the lid 21 so that the boat 26 placed on the rotation table 24 is loaded into the processing container 11, and moves down the lid 21 so that the boat 26 placed on the rotation table 24 is unloaded from the processing container 11.

As shown in Fig. 2, the controlling part 100 consists of a thermal-model storing part 111, a recipe storing part 112, a ROM 113, a RAM 114, an I/O port 115, a CPU 116, and bus lines 117 for connection of these elements.

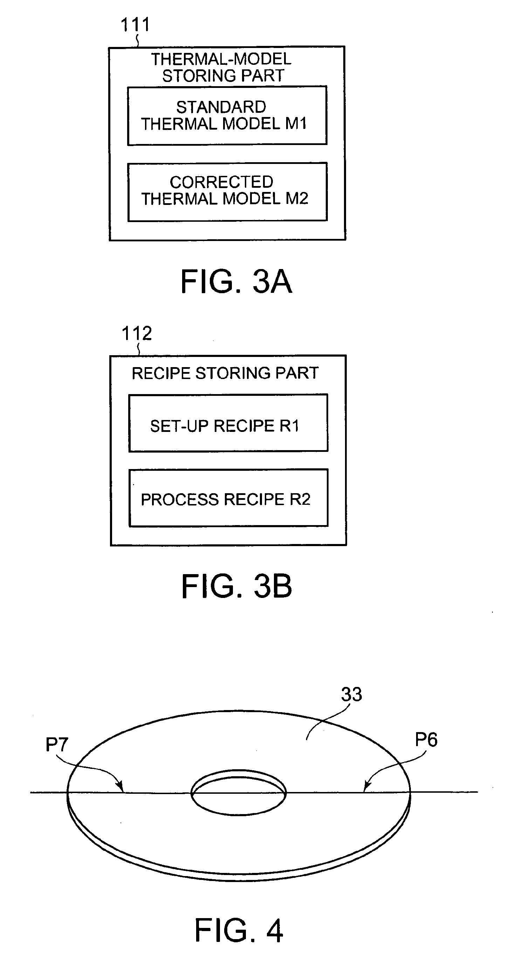

In the thermal-model storing part 111, as shown in Fig. 3A, stored are a standard thermal model M1 made by using a standard apparatus having the same specification as the thermal processing apparatus 1, and a corrected thermal model M2 generated by correcting the standard thermal model M1 for the thermal processing apparatus 1. Just after the thermal processing apparatus 1 has been manufactured, only the standard thermal model M1 is stored in the thermal-model storing part 111. Through a set-up operation of the thermal processing apparatus 1, the standard thermal model M1 is modified, and the corrected thermal model M2 is generated and stored in the thermal-model storing part 111.

Both the standard thermal model M1 and the corrected thermal model M2 are models (mathematical models: high-order multi-dimensional matrix) for forecasting temperatures in the processing container 11, from the output signals (measured temperatures) of the temperature sensors S1 to S5 and electric power supplied to the heaters 31a to 33 (instruction values showing supply electric power from the heater controller 123 connected to the heaters 31a to 33) and the like. Herein, the standard thermal model M1 that has been generated by the standard apparatus is common for a plurality of thermal processing apparatuses 1 having the same specification. On the other hand, the corrected thermal model M2 has been generated at a set-up operation of a specific thermal processing apparatus 1 in such a manner that thermal properties of the specific thermal processing apparatus are accurately reflected, and is to be used for an actual operation (of conducting a thermal process).

More specifically, the standard thermal model M1 forecasts, from the output signals (measured temperatures) of the temperature sensors S1 to S5 and the supply electric power to the heaters 31a to 33 and the like, a temperature of a central portion P1 of a wafer W placed on an upper portion of the boat 26 (boat-upper wafer), a temperature of a peripheral portion P2 of the boat-upper wafer, a temperature of a central portion P3 of a wafer W placed on a central portion of the boat 26 (boat-central wafer), a temperature of a central portion P4 of a wafer W placed on a lower portion of the boat 26 (boat-lower wafer), a temperature of a peripheral portion P5 of the boat-lower wafer, a temperature of the temperature sensor S4 arranged in the upper portion of the boat 26, temperatures of two points P6, P7 on the lower heater 33, and temperatures of predetermined positions P8, P9 on the inside surface of the side wall of the processing container 11 (see Fig. 1).

The reason why a temperature of a peripheral portion of the boat-central wafer is not measured is that the central portion of the boat 26 is thermally stable so that there is no substantial temperature difference between at the central portion P3 and at the peripheral portion. That is, the temperature of the central portion P3 can solely represent the temperature of the whole boat-central wafer W.

As shown in Fig. 4, the temperature measurement positions P6 and P7 on the lower heater 33 are located symmetrical with respect to the center of the doughnut-shaped lower heater 33.

In addition, the positions P8 and P9 on the inside surface of the side wall of the processing container 11 are respectively located at about 1/3 and 2/3 between the upper end and the lower end of the processing container 11.

In addition, the standard thermal model M1 calculates electric power to be supplied to the respective heaters 31a, 31b, 31c, 32 and 33, based on the forecasted temperatures at the ten positions (the positions P1 to P9 and the sensor S4), in order for the forecasted temperatures to coincide with the temperatures (target values) defined in the recipe. Herein, a method of generating the standard thermal model M1 is disclosed in USP 5,517,594, for example.

The corrected thermal model M2 is the same as the standard thermal model M1 except that the corrected thermal model M2 has been corrected based on the thermal properties inherent in the thermal processing apparatus 1 so as to accurately forecast the temperatures at the respective positions.

As shown in Fig. 3B, a set-up recipe R1 and a plurality of process recipes R2 are stored in the recipe-storing part 112 of Fig. 2.

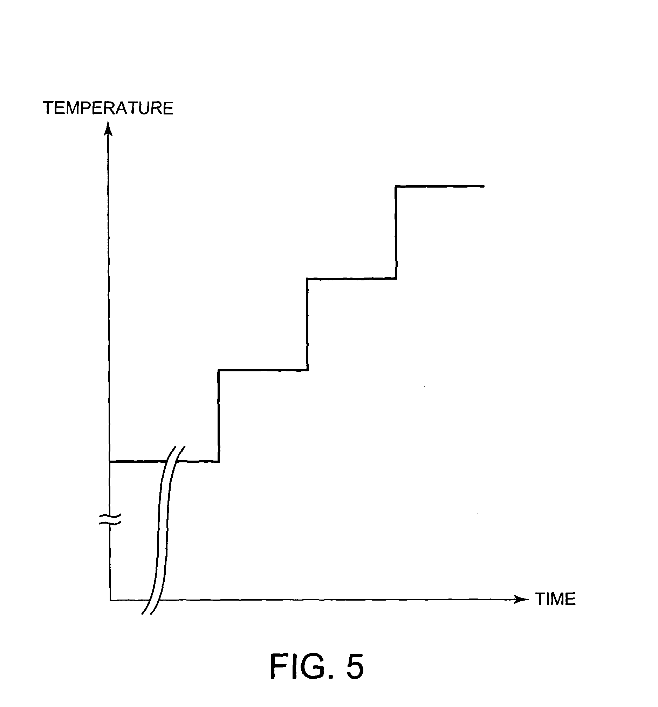

Just after the thermal processing apparatus 1 has been manufactured, only the set-up recipe R1 is stored. The set-up recipe R1 is carried out when the standard thermal model M1 of the thermal processing apparatus 1 is corrected to generate the corrected thermal model M2. As shown in Fig. 5, the set-up recipe R1 defines raising of the temperatures at the temperature measurement positions P1 to P9 and at the sensor S4 stepwise with respect to time. In addition, the set-up recipe R1 defines a pressure in the processing container 11, a kind of gas supplied into the processing container, a flow rate of the gas, a gas supply starting timing, a gas supply stopping timing, and the like.

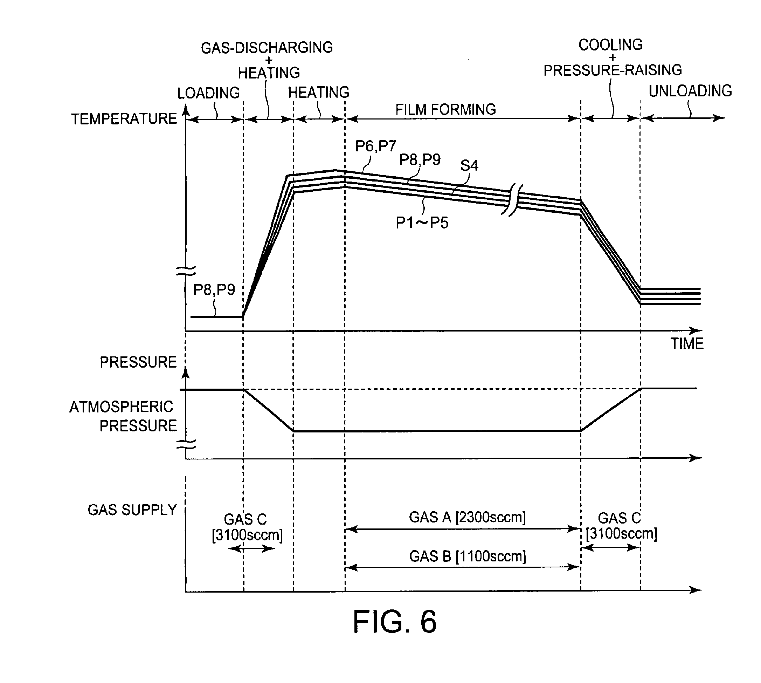

On the other hand, the process recipes R2 are prepared for respective actual thermal processes by the user. As shown in Fig. 6, a process recipe R2 of the present embodiment defines temperature changes of the respective positions, a pressure change in the processing container, a process-gas supply starting timing, a process-gas supply stopping timing, a flow rate of the process gas, and so on, from a loading step of the semiconductor wafers W into the processing container 11 till an unloading step of the processed wafers W.

The process recipes R2 defines changes of: the temperatures at the temperature measurement positions P1 to P5 of the wafers W, the temperature of the temperature sensor S4, the temperatures at the temperature measurement positions P6, P7 of the lower heater 33, and the temperatures at the temperature measurement positions P8, P9 on the inside surface of the side wall of the processing container 11, for each process.

The controlling part 100 of the thermal processing apparatus 1 forecasts the temperatures at the temperature measurement positions P1 to P5 of the wafers W, based on the measured temperatures of the temperature sensors S1 to S5 and the supply electric power supplied from the heater controller 123 to the respective heaters and the like, and controls the heaters 31a to 33 in such a manner that the forecasted temperatures coincide with the temperatures defined in the process recipe R2. Furthermore, the controlling part 100 forecasts the temperature of the temperature sensor S4, the temperatures at the temperature measurement positions P6, P7 of the lower heater 33, and the temperatures at the temperature measurement positions P8, P9 on the inside surface of the side wall of the processing container 11, based on the measured temperatures of the temperature sensors S1 to S5 and the supply electric power supplied from the heater controller 123 to the respective heaters and the like, and controls the heaters 31a to 33 in such a manner that the forecasted temperatures coincide with the temperatures defined in the process recipe R2.

The ROM 113 as shown in Fig. 2 is a storage medium formed by an EEPROM, a flash memory, a hard disk, or the like, and stores an operational program for the CPU 116 or the like. The RAM 114 serves as a work area of the CPU 116.

The I/O port 115 is connected to the temperature sensors S1 to S5, the operational panel 121, the pressure gauges 122, the heater controller 123, the massflow controller 124, the valve opening/closing controller 125, the vacuum pump 126, the boat elevator 127, and the like, and controls input/output of data and signals.

The bus lines 117 are used for transmitting information between the respective components.

The CPU (Central Processing Unit) 116 forms a center of the controlling part 100. The CPU 116 carries out a control program stored in the ROM 113, and controls an operation of the thermal processing apparatus 1 in accordance with instructions from the operational panel 121 and/or any recipe stored in the recipe-storing part 112.

Next, a temperature measuring apparatus 51 used in a set-up operation of the thermally processing apparatus 1 is explained.

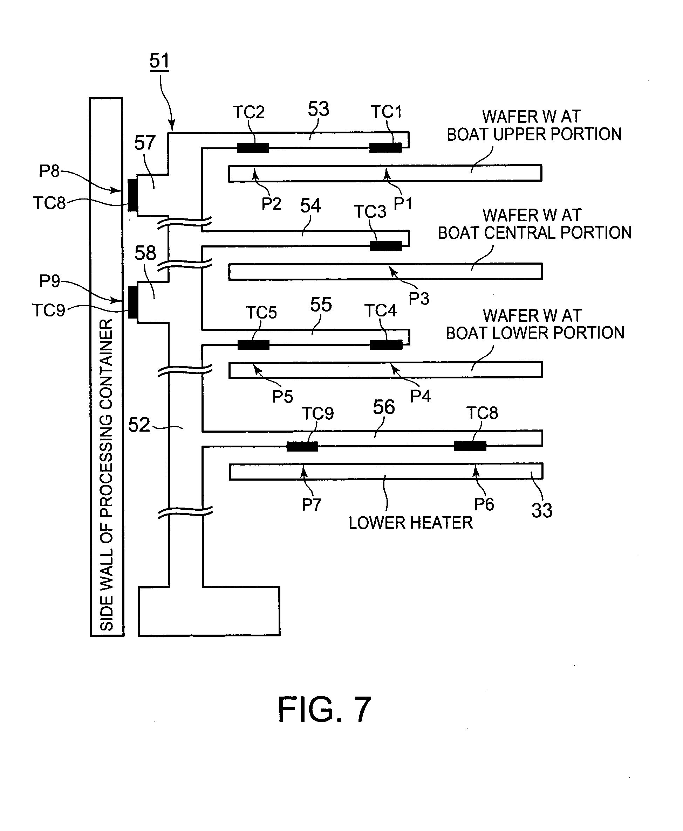

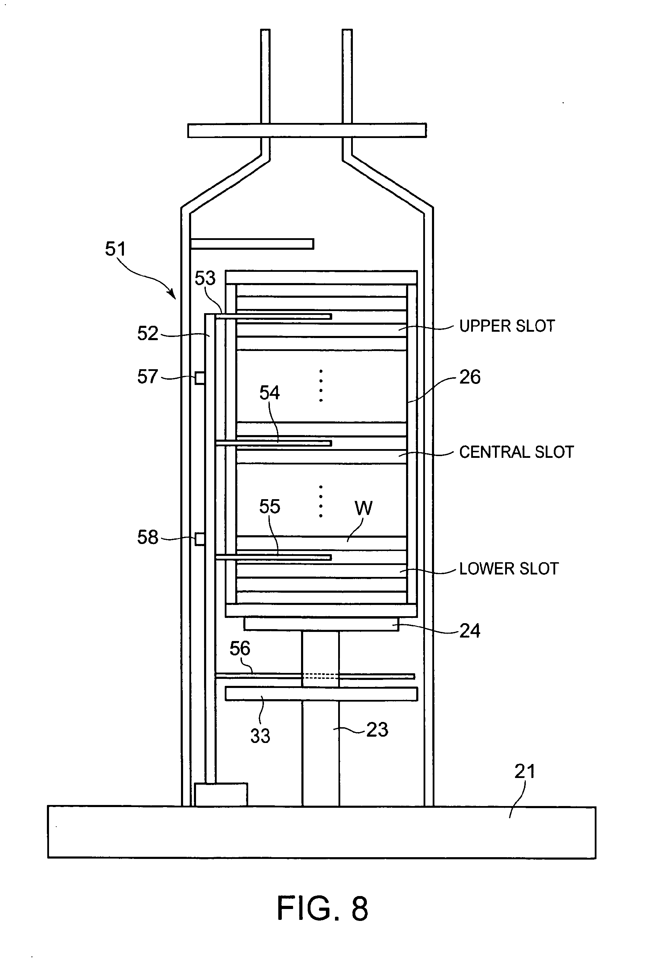

As shown in Fig. 7, the temperature measuring apparatus 51 comprises a column 52, and first to sixth arm portions 53 to 58, each of which extends in a horizontal direction from the column 52. As shown in Fig. 8, the first, second and third arm portions 53, 54, 55 extend to be capable of being inserted into an upper slot, a central slot and a lower slot of the boat 26, respectively. The fourth arm portion 56 avoids the rotation column 23 and extends to face the temperature measurement positions P6, P7 of the lower heater 33 nearby. The fifth and sixth arm portions 57, 58 extend to face the temperature measurement positions P8, P9 of the side wall of the processing container 11, respectively.

As shown in Fig. 7, on the first arm portion 53, thermocouples TC1 and TC2 are arranged at positions respectively corresponding to the central portion P1 and the peripheral portion P2 of the boat upper wafer W.

On the second arm portion 54, a thermocouple TC3 is arranged at a position corresponding to the central portion P3 of the boat central wafer W.

On the third arm portion 55, thermocouples TC4 and TC5 are arranged at positions respectively corresponding to the central portion P4 and the peripheral portion P5 of the boat lower wafer W.

On the fourth arm portion 56, thermocouples TC6 and TC7 are arranged at positions respectively corresponding to the temperature measurement positions P6 and P7 of the lower heater 33.

On the fifth arm portion 57, a thermocouple TC8 is arranged at a position corresponding to the temperature measurement position P8 of the side wall of the processing container 11.

On the sixth arm portion 58, a thermocouple TC9 is arranged at a position corresponding to the temperature measurement position P9 of the side wall of the processing container 11.

The thermocouples TC1 to TC9 are arranged close to the respective temperature measurement positions P1 to P9 in a noncontact manner, and are capable of measuring the temperatures of the respective temperature measurement positions P1 to P9 accurately. Output signal lines from the thermocouples TC are connected to the I/O port 115 of the controlling part 100 at the set-up operation.

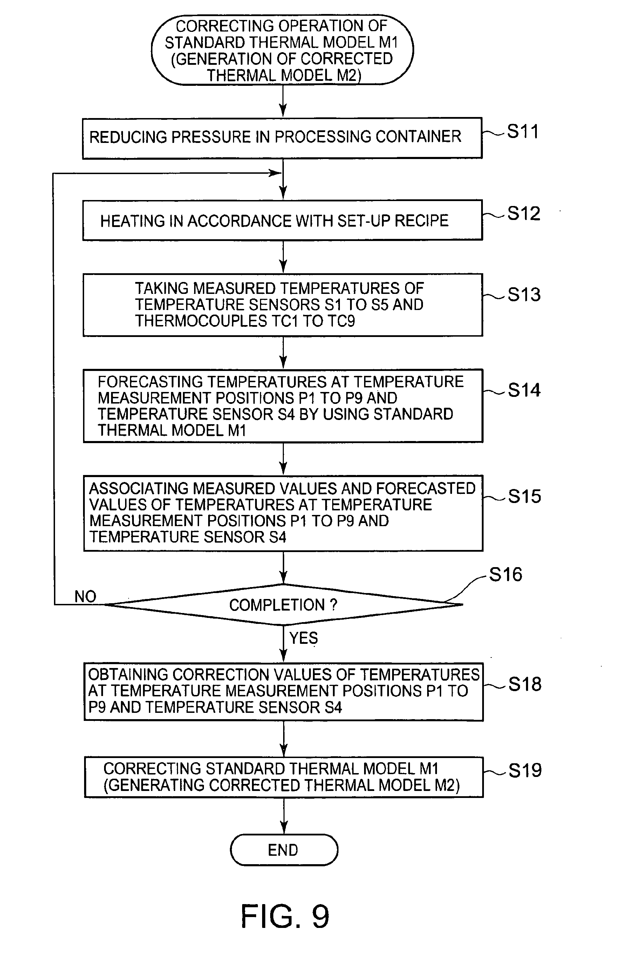

Next, the set-up operation of the thermally processing apparatus 1 is explained with reference to the flow chart of Fig. 9. The set-up operation is an operation of obtaining a minute difference of thermal properties between the individual thermal processing apparatus 1 and the standard apparatus, and of correcting the standard thermal model M1 stored in the thermal-model storing part 111 in order to generate the corrected thermal model M2 specific to the thermal processing apparatus 1.

At first, an operator arranges (loads) the boat 26 holding dummy wafers W and the temperature measuring apparatus 51 into the processing container 11. Specifically, the operator operates the operational panel 121 to instruct moving-down of the wafer boat lid 21. In response to the instructions, the controlling part 100 (CPU 116) moves down the boat elevator 127, and thus moves down the wafer boat lid 21. When the wafer boat lid 21 is moved down, the operator arranges the boat 26 holding the dummy wafers W onto the rotation table 24 by means of a robot not shown. In addition, by means of the robot not shown, the operator places the temperature measuring apparatus 51 onto the lid 21, and positions the first to sixth arm portions 53 to 58 at the predetermined positions shown in Figs. 7 and 8. Then, the operator operates the operational panel 121 to instruct moving-up of the wafer boat lid 21. In response to the instructions, the controlling part 100 (CPU 116) moves up the boat elevator 127, and thus moves up the lid 21, so that the boat 26 and the temperature measuring apparatus 51 are loaded into the processing container 11.

Then, the operator operates the operational panel 121 to instruct a start of a correcting operation of the standard thermal model M1.

In response to the instructions, the controlling part 100 starts the following steps in accordance with a program for the correcting operation stored in the ROM 113.

At first, the controlling part 100 controls the valve opening/closing controller 125 and the vacuum pump 126 in order to reduce a pressure in the processing container 11 to a predetermined pressure, while monitoring outputs of the pressure gauges 122 (step S11).

Then, the controlling part 100 sets target temperatures of the temperature measurement positions P1 to P9 and of the sensor S4 in the processing container 11 to a first temperature (for example, 500 °C), in accordance with the set-up recipe R1 (step S12).

When the temperatures in the processing container 11 are stabilized, by means of the temperature sensors S1 to S5 and the thermocouples TC1 to TC9, temperatures of the respective temperature measurement positions are actually measured (step S13).

Then, information about the measured temperatures of the temperature sensors S1 to S5 and the electric power supplied to the heaters 31 to 33 and the like is applied to the standard thermal model M1. Thus, the temperatures at the temperature measurement positions P1 to P9 (the temperature measurement positions P1 to P5 at the central and peripheral portions of the monitor wafers W, the temperature measurement positions P6, P7 of the lower heater 33, and the temperature measurement positions P8, P9 on the inside surface of the side wall of the processing container 11) and at the temperature sensor S4 are forecasted (step S14).

Then, the forecasted values and the measured values of the temperature measurement positions P1 to P9 and the temperature sensor S4 are associated with each other, and are stored in the RAM 114 (step S15).

Then, the controlling part 100 judges whether the set-up operation for all the temperatures that have been set in the set-up recipe R1 is completed or not (step S16). If not (step S16; No), the process returns to the step S12, and the same steps for the next set temperature are repeated.

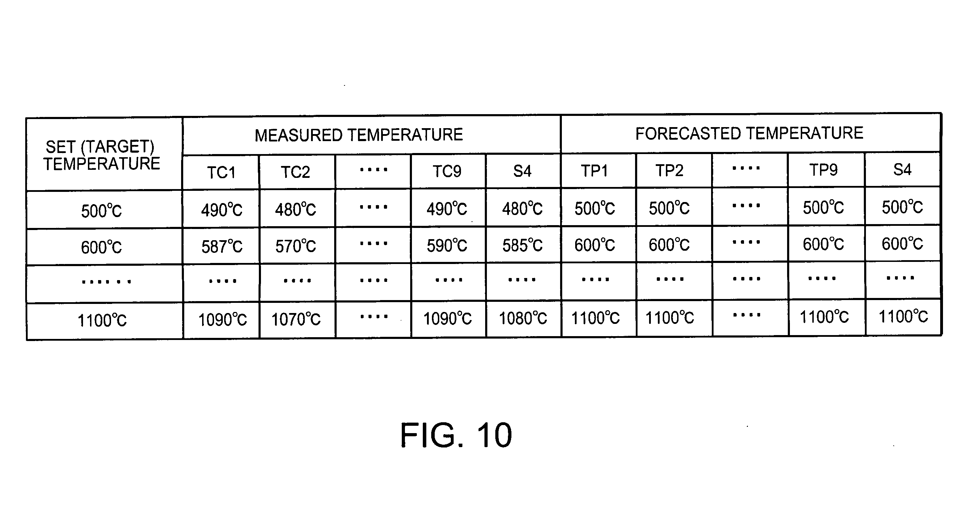

On the other hand, when the set-up operation for all the temperatures that have been set in the set-up recipe R1 is completed (step S16; Yes), as shown in Fig. 10, a corresponding table of the forecasted temperatures and the measured temperatures is obtained in the RAM 114. Then, the process proceeds to step S18.

In the step S18, based on the corresponding table formed in the RAM 114, the temperatures TR1 to TR9 measured by the thermocouples TC1 to TC9 and the temperature TR10 measured by the temperature sensor S4, and the temperatures TP1 to TP9 at the temperature measurement positions P1 to P9 and the temperature TP10 at the temperature sensor S4 forecasted by means of the standard thermal model M1 are respectively compared, so that correction values for the temperatures of the wafers W are obtained.

The method of obtaining the correction values is not limited. For example, the correction values can be obtained in accordance with the following expression 1.

$$\text{Correction Value } A_i = \text{Forecasted Value } TP_i \text{ by Standard Thermal Model M1} - \text{Measured Value } TR_i \text{ (expression 1)}$$

Herein, the suffix "i" means any of 1 to 9 corresponding to the temperature measurement positions P1 to P9, or 10 corresponding to the temperature sensor S4.

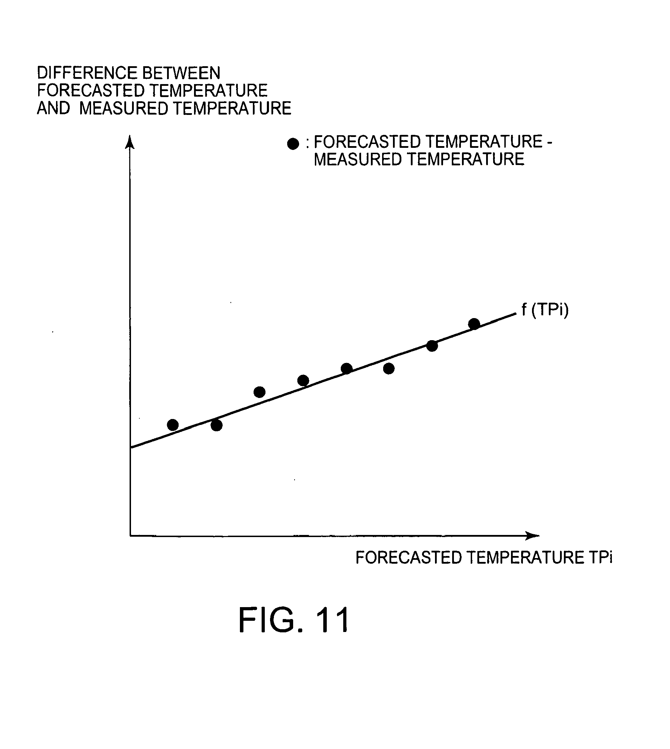

The collection value $A_i$ may be expressed as a function of "i". For example, when the forecasted values $TP_i$ - the measured values $TR_i$ are dispersed as shown in Fig. 11, a linear function $f(TP_i)$ for representing them is obtained by means of a least square method, so that the linear function $f(TP_i)$ may be used as the collection value $A_i$.

Then, the corrected thermal model M2 is created by correcting the standard thermal model M1, and stored in the thermal-model storing part 111 (step S19). That is, as shown in the following expression 2, the corrected thermal model M2 is created so as to forecast a value corrected by the collection value $A_i$ from the forecasted value $TP_i$ by the standard thermal model M1, and is stored in the thermal-model storing part 111.

$$\text{Forecasted Value } TQ_i \text{ by Corrected Thermal Model M2 =}$$
$$\text{Forecasted Value } TP_i \text{ by Standard Thermal Model M1 } - \text{ Correction Value}$$
$$A_i \text{ (expression 2)}$$

For example, if the Correction Value $A_i$ is represented as the function $f(TP_i)$ as shown in Fig. 11 and a forecasted temperature by the standard thermal model M1 is TO, the standard thermal model M1 is corrected in such a manner that the forecasted temperature amounts to T0 - f(TO).

As described above, the standard thermal model M1 is corrected for the thermal processing apparatus 1, so that the corrected thermal model M2 is obtained.

After that, the controlling part 100 moves down the boat elevator 127, and moves down the lid 21, so that the boat 26 and the temperature measuring apparatus 51 are unloaded. Then, the operator operates the operational panel 121 to convey out the boat 26 and the temperature measuring apparatus 51 from the processing container 11 by means of the robot not shown.

The corrected thermal model M2 stored in the thermal-model storing part 111 is used for forecasting temperatures of the temperature measurement positions P1 to P9 and the temperature sensor S4 during the subsequent actual process.

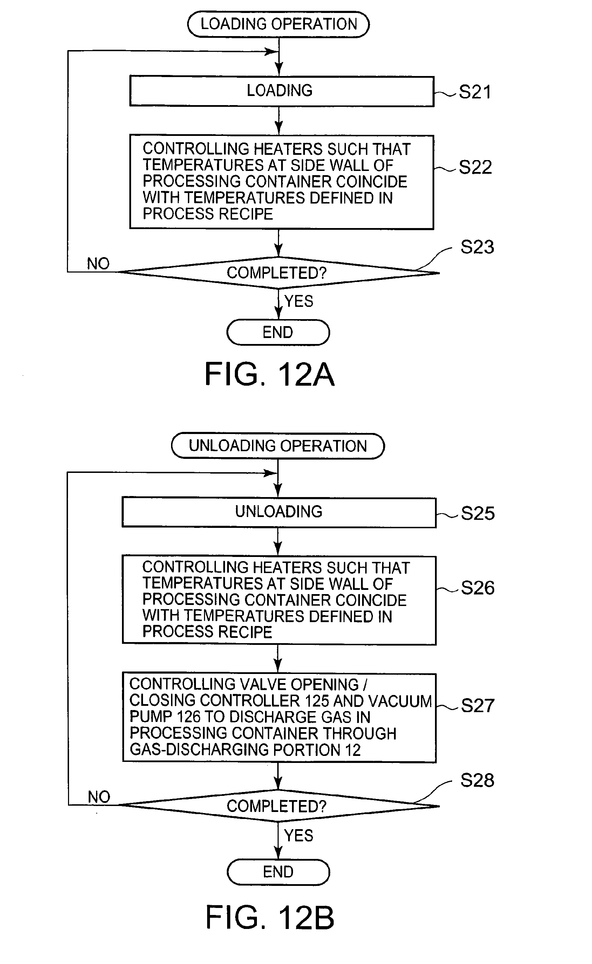

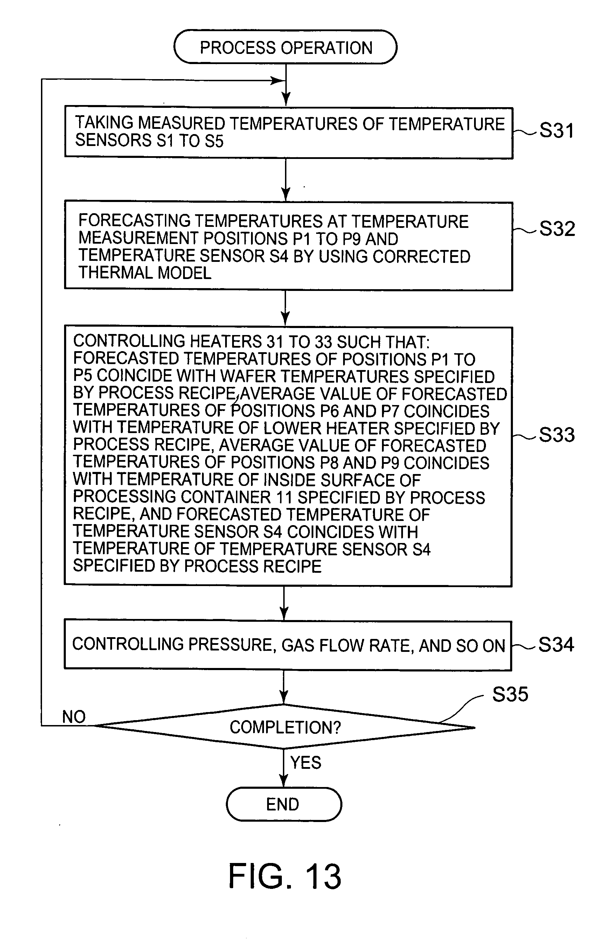

Then, an operation of conducting a thermal process such as a film-forming process or a diffusion process by using the corrected thermal model M2 is explained with reference to Figs. 12 and 13.

At first, the operator operates the operational panel 121 to identify a process to be carried out. In response to the instructions from the operational panel 121, the CPU 116 reads out a process recipe of the process to be carried out from the recipe storing part 112, and causes the RAM 114 to store the process recipe. Herein, assume that the recipe shown in Fig. 6 is selected.

The operator operates the operational panel 121 to place the boat 26 holding wafers W as objects to be processed onto the rotation table 24 by means of the robot not shown. Then, the operator instructs a loading operation of the boat 26. In response to the instructions, the controlling part 100 controls the boat elevator 127 to load the boat 26 while maintaining a temperature of the inside surface of the processing container 11 at a temperature specified by the process recipe.

To be specifically explained, as shown in Fig. 12A, the CPU 116 of the controlling part 100 repeats the operation of controlling the boat elevator 127 to load the boat 26 (step S21), and the operation of detecting the temperatures by the temperature sensors S1 to S5 and of controlling the heaters 31 to 33 via the heater controller 123 (step S22) in such a manner that the forecasted temperatures of the temperature measurement positions P8, P9 on the inside wall of the processing container 11 coincide with the temperatures defined in the process recipe, until completion of the loading operation of the boat 26 is detected (step S23; Yes).

When the loading operation of the boat 26 is completed, the controlling part 100 discharges the gas from the processing container 11, and controls the heaters 31 to 33 via the heater controller 123 in such a manner that the temperatures at the respective positions coincide with the temperatures defined in the recipe. When the gas-discharging operation in the processing container 11 is completed and the temperatures at the respective positions including the wafers in the processing container 11 coincide with the temperatures defined by the process recipe, the controlling part 100 starts supply of the process gas via the valve opening/closing controller 125.

After that, the pressure in the processing container 11, the temperatures at the respective positions, the gas flow rate, the gas-discharging volume, and the like are controlled in accordance with the recipe, while the thermal process is conducted. During that, the controlling part 100 controls the heaters 31 to 33 in such a manner that the respective forecasted temperatures at the temperature measurement positions P6, P7 of the lower heater 33, at the temperature measurement positions P8, P9 at the side wall of the processing container 11, and at the temperature sensor S4 coincide with the temperatures defined by the recipe.

To be specifically explained, as shown in Fig. 13, the CPU 116 measures the temperatures by the temperature sensors S1 to S5, and obtains measured values of the heater electric power (step S31).

Then, the CPU 116 applies the obtained measured values to the corrected thermal model M2, in order to forecast temperatures at the temperature measurement positions P1 to P9 and at the temperature sensor S4 (step S32).

Then, the CPU 116 controls electric power to be supplied to the heaters 31 to 33 via the heater controller 124 in such a manner that the forecasted temperatures at the temperature measurement positions P1 to P5 coincide with wafer temperatures specified by the process recipe, that an average value of the forecasted temperatures at the temperature measurement positions P6, P7 coincides with a temperature of the lower heater 33 specified by the process recipe, that an average value of the forecasted temperatures at the temperature measurement positions P8, P9 coincides with a temperature of the inside surface of the processing container 11 specified by the process recipe, and that the forecasted temperature at the temperature sensor S4 coincides with a temperature of the temperature sensor S4 specified by the process recipe (step S33).

Then, the CPU 116 takes measured values of the pressure gauges 122 and the mass flow controller 124 and the like, and controls the massflow controller 124, the valve opening/closing controller 125, the vacuum pump 126, and the like in such a manner that the pressure in the processing container 11, the gas flow rate, and the like coincide with their values defined in the process recipe.

Then, the CPU 116 judges whether the process is completed or not, for example whether the process has continued for a certain time or not (step S35). If not (step S35; NO), the process returns to the step S31, and continues. If completed (step S35; Yes), the thermal process ends, and a purging process or the like starts.

As described above, not only the forecasted temperatures (estimated temperatures) of the wafers W are controlled to coincide with the temperatures defined in the recipe, but also the forecasted temperatures of the portions in the processing container 11 other than the wafers W, concretely the lower heater 33, the side wall of the processing container 11 and the temperature sensor S4, are controlled to coincide with the temperatures defined in the recipe. Thus, compared with a case wherein only the temperatures of the wafers W are forecasted and controlled, fluctuation (dispersion) of gas-decomposing effect is inhibited, for example in a CVD process. Thus, the thermal process can be carried out under a state wherein fluctuation (dispersion) from the intended process is small, so that a result close to the intended result can be obtained.

Furthermore, when a recipe is appropriately set for each process, the gas-decomposing effect may be promoted or damped. Thus, a film-forming result that is preferable to the user can be obtained.

After the film-forming process is completed, the controlling part 100 controls the valve opening/closing controller 125, the vacuum pump 126, the heater controller 123, and the like, so that the supply of the process gas is stopped. Instead, while a purge gas is supplied and the process gas in the processing container 11 is discharged, the pressure in the processing container 11 is raised, and the inside of the processing container 11 is cooled.

When the pressure in the processing container 11 is raised to the atmospheric pressure and the temperature of the inside of the processing container 11 is reduced to a predetermined temperature, the controlling part 100 controls the boat elevator 127 to unload the boat 26. During the unloading operation, that is, while the wafers W are taken out from the processing container 11, the controlling part 100 controls the heaters 31 to 33 in such a manner that the forecasted temperatures at the temperature measurement positions P8, P9 on the inside surface of the processing container 11 are respectively maintained at constant temperatures that have been set in the recipe. In addition, during that, the controlling part 100 controls the vacuum pump 126 and the like in order to discharge particles generated in the processing container 11 through the gas-discharging portion 12.

To be concretely explained, as shown in Fig. 12B, the CPU 116 of the controlling part 100 repeats the operation of controlling the boat elevator 127 to unload the boat 26 (step S25), the operation of detecting the temperatures by the temperature sensors S1 to S5 and of controlling the heaters 31 to 33 via the heater controller 123 (step S26) in such a manner that the forecasted temperatures of the temperature measurement positions P8, P9 on the inside wall of the processing container 11 coincide with the temperatures defined in the process recipe, and the operation of controlling the vacuum pump 126 in order to discharge the gas from the process container 11 (step S27), until completion of the unloading operation of the boat 26 is detected (step S28; Yes).

When the unloading operation of the boat 26 is completed, the operator operates the operational panel 121 to take out the boat 26 from on the rotation table 24 by means of the robot not shown.

As described above, the thermal processing apparatus of the present embodiment forecasts not only temperatures of the wafers but also temperatures of the predetermined portions in the processing container 11 other than the wafers W (the temperatures sensor S4, the lower heater 33, and the inside surface of the processing container 11), and conducts a temperature control (heater control) in such a manner that the forecasted temperatures coincide with the temperatures that have been set in the recipe in advance. Thus, compared with the case wherein only the temperatures of the wafers W are forecasted and controlled, dispersion of the process is inhibited, so that a film-forming process can be conducted stably with high quality.

In addition, during the loading and unloading operation of the boat 26, the temperature of the inside surface of the processing container 11 is controlled at the substantially constant value. Thus, it can be prevented that the deposits on the inside surface of the processing container 11 are peeled off. Therefore, particle generation can be inhibited.

This invention is not limited to the above embodiment, but may be variously modified and developed. For example, in the above embodiment, during the thermal process, other than the temperatures of the wafers W, the forecasted temperatures of the lower heater 33, the temperature sensor S4 and the inside surface of the processing container 11 are controlled to coincide with the temperatures defined in the recipe. However, this invention is not limited to this manner. For example, during the thermal process, only the temperatures of the wafers W and the temperatures of the lower heater 33 and the temperature sensor S4 may be forecasted and controlled, excluding the temperatures of the inside surface of the processing container 11.

In addition, in the above embodiment, the temperatures of the temperature measurement positions P6, P7 of the lower heater 33 and of the temperature measurement positions P8, P9 of the inside surface of the processing container 11 are respectively forecasted, and controlled to coincide with the temperatures specified in the recipe. However, this invention is not limited to this manner. For example, only an average temperature of the temperature measurement positions P6, P7 of the lower heater 33 may be forecasted, and the heaters 31 to 33 may be controlled in order for the forecasted average temperature to coincide with the temperature specified in the recipe. Alternatively, only an average temperature of the temperature measurement positions P8, P9 of the inside surface of the processing container 11 may be forecasted, and the heaters 31 to 33 may be controlled in order for the forecasted average temperature to coincide with the temperature specified in the recipe.

In that case, a thermal model for forecasting the average temperature of the temperature measurement positions P6, P7 and/or the average temperature of the temperature measurement positions P8, P9 is stored in the thermal-model storing part 111, and a recipe of the average temperature of the temperature measurement positions P6, P7 and/or the average temperature of the temperature measurement positions P8, P9 is stored in the recipe storing part 112. The CPU 116 forecasts, based on the thermal model, the average temperature of the temperature measurement positions P6, P7 and/or the average temperature of the temperature measurement positions P8, P9, and controls the heaters 31 to 33 via the heater controller 123 in order for the forecasted average temperature to coincide with the temperature specified in the recipe.

The thermal model may individually forecast temperatures of the temperature measurement positions P6 to P9. In that case, the CPU 116 calculates an average value of the forecasted temperatures, and controls the heaters 31 to 33 via the heater controller 123 in such a manner that the average temperature of the temperature measurement positions P6, P7 and/or the average temperature of the temperature measurement positions P8, P9 respectively coincide with the temperatures defined in the recipe.

In addition, any other portion may become an object (target) of the temperature control. For example, a temperature at any portion of the boat 26 and/or a temperature of the temperature sensor S5 may be forecasted and controlled. In that case, a model for forecasting a temperature at a predetermined portion of the boat 26 and/or a temperature of the temperature sensor S5 is generated, and an optimum recipe of the temperature at a predetermined portion of the boat 26 and/or the temperature (including temperature change) of the temperature sensor S5 is made for a process. Then, the heater 31 is controlled in such a manner that the forecasted temperatures of the boat 26 and the temperature sensor S5 coincide with the temperatures defined in the recipe.

Any portion may become an object (target) of the temperature control. However, a portion whose temperature has a direct or indirect effect on the process is preferably selected and set, taking into account a flow of the process gas, pressure distribution, and the like.

Furthermore, the number of the temperatures sensors and/or the arrangement thereof may be suitably changed. The number is not limited to five, and the arrangement may be on the inside wall of the processing container 11.

The thermal processing apparatus 1 to which the present invention has been applied may be freely modified, not limited to the above embodiment. For example, the processing container 11 may have a double-tube structure, and the number of the semiconductor wafers W capable of being placed on the boat 26 may be larger (for example, 100 to 150) or smaller (for example, 15 to 30).

In addition, the thermal process is not limited. That is, the present invention is applicable to not only the CVD apparatus, but also an oxidizing apparatus, an etching apparatus, and any other batch type of thermal processing apparatus.

The components' structures and the components' operations are not limited to the above embodiment. For example, in the above embodiment, the number of side heaters is three, and the number of inside heaters is two. However, the number of heaters and the arrangement thereof are not limited. In addition, the heater is not limited to the electrical resistance type, but may be a heating lamp. In addition, the structure for measuring the temperatures of the wafers is not limited to the thermocouples, but may be any temperature sensor.

The thermal model and the designing method thereof are not limited to those disclosed in USP 5,517,594, but any model and any designing method may be adopted.

Furthermore, in the above embodiment, in generating the thermal model, the temperature of the upper heater 32 is substituted by the temperature of the temperature sensor S4, and the temperature of the lower heater 33 is directly measured by the thermocouples TC8, TC9. However, any other method is available. For example, a radiation thermometer may be used to measure the temperature.

In addition, the controlling part 100 of the above embodiment may be either an exclusive system or a general-purpose computer system. For example, a program for carrying out the above correcting operation may be installed in a general-purpose computer system, so that the general-purpose computer system may be used as the controlling part 100. For example, (at least one part of) the computer program for carrying out the above correcting operation may be stored in a storage medium capable of being read by a computer, such as a CD-ROM and a DVD-ROM, and may be distributed. The computer program may be transmitted to the RAM 114 through the I/O port 115. The transmitted program is executed by the CPU 116, so that the above correcting operation is carried out.

In addition, a means for supplying the computer program into the computer system is not limited. That is, the computer program may be supplied via a communication line, a communication network, a communication system, or the like, instead of the above predetermined storage medium. Specifically, a program displayed on a bulletin board system (BBS) of a communication network may be overlapped with a carrier wave through a network, and transmitted to the I/O port 115.

Herein, the computer program may be executed under a control by an OS, in a general-purpose computer, similarly to the other application software.

1. A thermal processing apparatus comprising:

   a processing container for containing an object to be processed,
   a plurality of heaters for heating the object to be processed,
   a plurality of temperature sensors for respectively detecting temperatures at a plurality of predetermined positions in the processing container,
   a storing part that stores: a thermal model for forecasting a temperature of the object to be processed contained in the processing container from outputs of the plurality of temperature sensors, and a recipe in which a desired temperature of the object to be processed is defined, and
   a controlling part that forecasts a temperature of the object to be processed by using the outputs of the plurality of temperature sensors and the thermal model, and that controls the plurality of heaters so as to cause the forecasted temperature of the object to be processed to coincide with the desired temperature of the object to be processed defined in the recipe,
   wherein
   the thermal model is configured to forecast, from the outputs of the plurality of temperature sensors, not only a temperature of the object to be processed contained in the processing container but also a temperature of at least one other predetermined portion in the processing container,
   a desired temperature of the predetermined portion is also defined in the recipe, and
   the controlling part is adapted to forecast a temperature of the object to be processed and a temperature of the predetermined portion by using the outputs of the plurality of temperature sensors and the thermal model, and to control the plurality of heaters so as to cause the forecasted temperature of the object to be processed and the forecasted temperature of the predetermined portion to respectively coincide with the desired temperature of the object to be processed and the desired temperature of the predetermined portion defined in the recipe.

2. A thermal processing apparatus according to claim 1, wherein
   an inside heater is arranged in the processing container as one of the plurality of heaters, and
   the at least one other predetermined portion in the processing container includes the inside heater in the processing container.

3. A thermal processing apparatus according to claim 1 or 2,
   wherein
   the at least one other predetermined portion in the processing container includes a predetermined portion of an inside wall surface of the processing container.

4. A thermal processing apparatus according to claim 1, wherein
   an upper heater and a lower heater are arranged correspondingly to an upper portion and a lower portion of the object to be processed contained in the processing container, as two of the plurality of heaters, and
   the at least one other predetermined portion in the processing container includes the upper heater and the lower heater.

5. A thermal processing apparatus according to claim 4, wherein
   a gas-discharging pipe is connected to an upper portion of the processing container, and
   the upper heater is arranged so as to surround the gas-discharging pipe.

6. A thermal processing apparatus according to claim 1, wherein

an upper heater and a lower heater are arranged correspondingly to an upper portion and a lower portion of the object to be processed contained in the processing container, as two of the plurality of heaters,

an upper temperature sensor is arranged between the object to be processed contained in the processing container and the upper heater, as one of the plurality of temperature sensors, and

the at least one other predetermined portion in the processing container includes the upper temperature sensor and the lower heater.

7. A thermal processing apparatus according to claim 6, wherein

a gas-discharging pipe is connected to an upper portion of the processing container, and

the upper heater is arranged so as to surround the gas-discharging pipe.

8. A thermal processing apparatus according to claim 1, further comprising

a unit of introducing a gas to a gas-introducing port of the processing container, and

a unit of discharging the gas from a gas-discharging port of the processing container,

wherein

the at least one other predetermined portion in the processing container is set between the gas-introducing port and a portion on the most downstream side of the object to be processed, along a path from the gas-introducing port to the gas-discharging port.

9. A thermal processing apparatus according to any of claims 1 to 8, wherein

the thermal model is configured to forecast, from the outputs of the plurality of temperature sensors during a thermal process, a temperature of the object to be processed contained in the processing container during the thermal process and a temperature of the at least one other predetermined portion in the processing container during the thermal process,

a desired temperature of the object to be processed during the thermal process and a desired temperature of the predetermined portion during the thermal process are defined in the recipe, and

the controlling part is adapted to forecast a temperature of the object to be processed during the thermal process and a temperature of the predetermined portion during the thermal process by using the outputs of the plurality of temperature sensors and the thermal model, and to control the plurality of heaters so as to cause the forecasted temperature of the object to be processed and the forecasted temperature of the predetermined portion to respectively coincide with the desired temperature of the object to be processed during the thermal process and the desired temperature of the predetermined portion during the thermal process defined in the recipe.

10. A thermal processing apparatus according to claim 1, further comprising

a loading/unloading unit that loads an object to be processed into the processing container and, that unloads the object to be processed from the processing container after a thermal process.

11. A thermal processing apparatus according to claim 10, wherein

the thermal model is configured to forecast, from the outputs of the plurality of temperature sensors during a loading and/or unloading process, a temperature of the object to be processed contained in the processing container during the loading and/or unloading process and a temperature of the at least one other predetermined portion in the processing container during the loading and/or unloading process,

a desired temperature of the object to be processed during the loading and/or unloading process and a desired temperature of the predetermined portion during the loading and/or unloading process are defined in the recipe, and

the controlling part is adapted to forecast a temperature of the object to be processed during the loading and/or unloading process and a temperature of the predetermined portion during the loading and/or unloading process by using the outputs of the plurality of temperature sensors and the thermal model, and to control the plurality of heaters so as to cause the forecasted temperature of the object to be processed and the forecasted temperature of the predetermined portion to respectively coincide with the desired temperature of the object to be processed during the loading and/or unloading process and the desired temperature of the predetermined portion during the loading and/or unloading process defined in the recipe.

12. A thermal processing method of controlling a thermal processing apparatus including:

a processing container for containing an object to be processed,

a plurality of heaters for heating the object to be processed, and

a plurality of temperature sensors for respectively detecting temperatures at a plurality of predetermined positions in the processing container,

the thermal processing method comprising:

a forecasting step of forecasting a temperature of the object to be processed and a temperature of at least one other predetermined portion in the processing container by applying outputs of the plurality of temperature sensors to a thermal model that has been set in advance, and

a controlling step of controlling the plurality of heaters so as to cause the forecasted temperature of the object to be processed and the forecasted temperature of the predetermined portion to respectively coincide with a desired temperature of the object to be processed and a desired temperature of the predetermined portion that have been defined in advance.

13. A program for controlling a thermal processing apparatus including:

a processing container for containing an object to be processed,
a plurality of heaters for heating the object to be processed, and
a plurality of temperature sensors for respectively detecting temperatures at a plurality of predetermined positions in the processing container,
the program being adapted to cause a computer to execute:
a forecasting step of forecasting a temperature of the object to be processed and a temperature of at least one other predetermined portion in the processing container by applying outputs of the plurality of temperature sensors to a thermal model that has been set in advance, and

a controlling step of controlling the plurality of heaters so as to cause the forecasted temperature of the object to be processed and the forecasted temperature of the predetermined portion to respectively coincide with a desired temperature of the object to be processed and a desired temperature of the predetermined portion that have been defined in advance.

14. A storage medium capable of being read by a computer, storing a program for controlling a thermal processing apparatus including:

a processing container for containing an object to be processed,
a plurality of heaters for heating the object to be processed, and
a plurality of temperature sensors for respectively detecting temperatures at a plurality of predetermined positions in the processing container,
the program being adapted to cause a computer to execute:
a forecasting step of forecasting a temperature of the object to be processed and a temperature of at least one other predetermined portion in the processing container by applying outputs of the plurality of temperature sensors to a thermal model that has been set in advance, and
a controlling step of controlling the plurality of heaters so as to cause the forecasted temperature of the object to be processed and the forecasted temperature of the predetermined portion to respectively coincide with a desired temperature of the object to be processed and a desired temperature of the predetermined portion that have been defined in advance.

15. A controlling unit for controlling a thermal processing apparatus including:

a processing container for containing an object to be processed,
a plurality of heaters for heating the object to be processed, and
a plurality of temperature sensors for respectively detecting temperatures at a plurality of predetermined positions in the processing container,
the controlling unit comprising:
a storing part that stores: a thermal model for forecasting a temperature of the object to be processed contained in the processing container from outputs of the plurality of temperature sensors, and a recipe in which a desired temperature of the object to be processed is defined, and
a controlling part that forecasts a temperature of the object to be processed by using the outputs of the plurality of temperature sensors and the thermal model, and that controls the plurality of heaters so as to cause the forecasted temperature of the object to be processed to coincide with the desired temperature of the object to be processed defined in the recipe,
wherein
the thermal model is configured to forecast, from the outputs of the plurality of temperature sensors, not only a temperature of the object to be processed contained in the processing container but also a temperature of at least one other predetermined portion in the processing container,

a desired temperature of the predetermined portion is also defined in the recipe, and

the controlling part is adapted to forecast a temperature of the object to be processed and a temperature of the predetermined portion by using the outputs of the plurality of temperature sensors and the thermal model, and to control the plurality of heaters so as to cause the forecasted temperature of the object to be processed and the forecasted temperature of the predetermined portion to respectively coincide with the desired temperature of the object to be processed and the desired temperature of the predetermined portion defined in the recipe.

16. A program executed by a computer system including at least a computer, in order to materialize in the computer system a controlling unit,

the controlling unit being adapted to control a thermal processing apparatus including: a processing container for containing an object to be processed, a plurality of heaters for heating the object to be processed, and a plurality of temperature sensors for respectively detecting temperatures at a plurality of predetermined positions in the processing container,

the controlling unit comprising:

a storing part that stores: a thermal model for forecasting a temperature of the object to be processed contained in the processing container from outputs of the plurality of temperature sensors, and a recipe in which a desired temperature of the object to be processed is defined, and

a controlling part that forecasts a temperature of the object to be processed by using the outputs of the plurality of temperature sensors and the thermal model, and that controls the plurality of heaters so as to cause the forecasted temperature of the object to be processed to coincide with the desired temperature of the object to be processed defined in the recipe,

wherein

the thermal model is configured to forecast, from the outputs of the plurality of temperature sensors, not only a temperature of the object to be processed contained in the processing container but also a temperature of at least one other predetermined portion in the processing container,

a desired temperature of the predetermined portion is also defined in the recipe, and

the controlling part is adapted to forecast a temperature of the object to be processed and a temperature of the predetermined portion by using the outputs of the plurality of temperature sensors and the thermal model, and to control the plurality of heaters so as to cause the forecasted temperature of the object to be processed and the forecasted temperature of the predetermined portion to respectively coincide with the desired temperature of the object to be processed and the desired temperature of the predetermined portion defined in the recipe.

17. A program including a command for controlling a second program operable in a computer system including at least a computer,

the program being executed by the computer system to control the second program to materialize in the computer system a controlling unit,

the controlling unit being adapted to control a thermal processing apparatus including: a processing container for containing an object to be processed, a plurality of heaters for heating the object to be processed, and a plurality of temperature sensors for respectively detecting temperatures at a plurality of predetermined positions in the processing container,

the controlling unit comprising:

a storing part that stores: a thermal model for forecasting a temperature of the object to be processed contained in the processing container from outputs of the plurality of temperature sensors, and a recipe in which a desired temperature of the object to be processed is defined, and

a controlling part that forecasts a temperature of the object to be processed by using the outputs of the plurality of temperature sensors and the thermal model, and that controls the plurality of heaters so as to cause the forecasted temperature of the object to be processed to coincide with the desired temperature of the object to be processed defined in the recipe,

wherein

the thermal model is configured to forecast, from the outputs of the plurality of temperature sensors, not only a temperature of the object to be processed contained in the processing container but also a temperature of at least one other predetermined portion in the processing container,

a desired temperature of the predetermined portion is also defined in the recipe, and

the controlling part is adapted to forecast a temperature of the object to be processed and a temperature of the predetermined portion by using the outputs of the plurality of temperature sensors and the thermal model, and to control the plurality of heaters so as to cause the forecasted temperature of the object to be processed and the forecasted temperature of the predetermined portion to respectively coincide with the desired temperature of the object to be processed and the desired temperature of the predetermined portion defined in the recipe.

18. A storage medium capable of being read by a computer, storing a program,
the program being executed by a computer system including at least a computer in order to materialize in the computer system a controlling unit,
the controlling unit being adapted to control a thermal processing apparatus including: a processing container for containing an object to be processed, a plurality of heaters for heating the object to be processed, and a plurality of temperature sensors for respectively detecting temperatures at a plurality of predetermined positions in the processing container,
the controlling unit comprising:

a storing part that stores: a thermal model for forecasting a temperature of the object to be processed contained in the processing container from outputs of the plurality of temperature sensors, and a recipe in which a desired temperature of the object to be processed is defined, and
a controlling part that forecasts a temperature of the object to be processed by using the outputs of the plurality of temperature sensors and the thermal model, and that controls the plurality of heaters so as to cause the forecasted temperature of the object to be processed to coincide with the desired temperature of the object to be processed defined in the recipe,
wherein
the thermal model is configured to forecast, from the outputs of the plurality of temperature sensors, not only a temperature of the object to be processed contained in the processing container but also a temperature of at least one other predetermined portion in the processing container,
a desired temperature of the predetermined portion is also defined in the recipe, and
the controlling part is adapted to forecast a temperature of the object to be processed and a temperature of the predetermined portion by using the outputs of the plurality of temperature sensors and the thermal model, and to control the plurality of heaters so as to cause the forecasted temperature of the object to be processed and the forecasted temperature of the predetermined portion to respectively coincide with the desired temperature of the object to be processed and the desired temperature of the predetermined portion defined in the recipe.

19. A storage medium capable of being read by a computer, storing a program,
the program including a command for controlling a second program operable in a computer system including at least a computer,
the program being executed by the computer system to control the second program to materialize in the computer system a controlling unit,
the controlling unit being adapted to control a thermal processing apparatus including: a processing container for containing an object to be processed, a plurality of heaters for heating the object to be processed, and a plurality of temperature sensors for respectively detecting temperatures at a plurality of predetermined positions in the processing container,
the controlling unit comprising:

a storing part that stores: a thermal model for forecasting a temperature of the object to be processed contained in the processing container from outputs of the plurality of temperature sensors, and a recipe in which a desired temperature of the object to be processed is defined, and
a controlling part that forecasts a temperature of the object to be processed by using the outputs of the plurality of temperature sensors and the thermal model, and that controls the plurality of heaters so as to cause the forecasted temperature of the object to be processed to coincide with the desired temperature of the object to be processed defined in the recipe,
wherein
the thermal model is configured to forecast, from the outputs of the plurality of temperature sensors, not only a temperature of the object to be processed contained in the processing container but also a temperature of at least one other predetermined portion in the processing container,
a desired temperature of the predetermined portion is also defined in the recipe, and
the controlling part is adapted to forecast a temperature of the object to be processed and a temperature of the predetermined portion by using the outputs of the plurality of temperature sensors and the thermal model, and to control the plurality of heaters so as to cause the forecasted temperature of the object to be processed and the forecasted temperature of the predetermined portion to respectively coincide with the desired temperature of the object to be processed and the desired temperature of the predetermined portion defined in the recipe.

**Claims**

1. A thermal processing apparatus comprising:

a processing container for containing an object to be processed,
a plurality of heaters for heating the object to be processed,
a plurality of temperature sensors for respectively detecting temperatures at a plurality of predetermined positions in the processing container,
a storing part that stores: a thermal model for forecasting a temperature of the object to be processed contained in the processing container from outputs of the plurality of temperature sensors, and a recipe in which a desired temperature of the object to be processed is defined, and
a controlling part that forecasts a temperature of the object to be processed by using the outputs of the plurality of temperature sensors and the thermal model, and that controls the plurality of heaters so as to cause the forecasted temperature of the object to be processed to coincide with the desired temperature of the object to be processed defined in the recipe,
wherein
the thermal model is configured to forecast, from the outputs of the plurality of temperature sensors, not only a temperature of the object to be processed contained in the processing container but also a temperature of at least one other predetermined portion in the processing container,
a desired temperature of the predetermined portion is also defined in the recipe, and
the controlling part is adapted to forecast a temperature of the object to be processed and a temperature of the predetermined portion by using the outputs of the plurality of temperature sensors and the thermal model, and to control the plurality of heaters so as to cause the forecasted temperature of the object to be processed and the forecasted temperature of the predetermined portion to respectively coincide with the desired temperature of the object to be processed and the desired temperature of the predetermined portion defined in the recipe.

2. A thermal processing apparatus according to claim 1, wherein
an inside heater is arranged in the processing container as one of the plurality of heaters, and
the at least one other predetermined portion in the processing container includes the inside heater in the processing container.

3. A thermal processing apparatus according to claim 1 or 2, wherein
the at least one other predetermined portion in the processing container includes a predetermined portion of an inside wall surface of the processing container.

4. A thermal processing apparatus according to claim 1, wherein
an upper heater and a lower heater are arranged correspondingly to an upper portion and a lower portion of the object to be processed contained in the processing container, as two of the plurality of heaters, and
the at least one other predetermined portion in the processing container includes the upper heater and the lower heater.

5. A thermal processing apparatus according to claim 4, wherein
a gas-discharging pipe is connected to an upper portion of the processing container, and
the upper heater is arranged so as to surround the gas-discharging pipe.

6. A thermal processing apparatus according to claim 1, wherein
an upper heater and a lower heater are arranged correspondingly to an upper portion and a lower portion of the object to be processed contained in the processing container, as two of the plurality of heaters,
an upper temperature sensor is arranged between the object to be processed contained in the processing container and the upper heater, as one of the plurality of temperature sensors, and
the at least one other predetermined portion in the processing container includes the upper temperature sensor and the lower heater.

7. A thermal processing apparatus according to claim 6, wherein
a gas-discharging pipe is connected to an upper portion of the processing container, and
the upper heater is arranged so as to surround the gas-discharging pipe.

**8.** A thermal processing apparatus according to claim 1, further comprising
a unit of introducing a gas to a gas-introducing port of the processing container, and
a unit of discharging the gas from a gas-discharging port of the processing container, wherein
the at least one other predetermined portion in the processing container is set between the gas-introducing port and a portion on the most downstream side of the object to be processed, along a path from the gas-introducing port to the gas-discharging port.

**9.** A thermal processing apparatus according to any of claims 1 to 8, wherein
the thermal model is configured to forecast, from the outputs of the plurality of temperature sensors during a thermal process, a temperature of the object to be processed contained in the processing container during the thermal process and a temperature of the at least one other predetermined portion in the processing container during the thermal process,
a desired temperature of the object to be processed during the thermal process and a desired temperature of the predetermined portion during the thermal process are defined in the recipe, and
the controlling part is adapted to forecast a temperature of the object to be processed during the thermal process and a temperature of the predetermined portion during the thermal process by using the outputs of the plurality of temperature sensors and the thermal model, and to control the plurality of heaters so as to cause the forecasted temperature of the object to be processed and the forecasted temperature of the predetermined portion to respectively coincide with the desired temperature of the object to be processed during the thermal process and the desired temperature of the predetermined portion during the thermal process defined in the recipe.

**10.** A thermal processing apparatus according to claim 1, further comprising
a loading/unloading unit that loads an object to be processed into the processing container and, that unloads the object to be processed from the processing container after a thermal process.

**11.** A thermal processing apparatus according to claim 10, wherein
the thermal model is configured to forecast, from the outputs of the plurality of temperature sensors during a loading and/or unloading process, a temperature of the object to be processed contained in the processing container during the loading and/or unloading process and a temperature of the at least one other predetermined portion in the processing container during the loading and/or unloading process,
a desired temperature of the object to be processed during the loading and/or unloading process and a desired temperature of the predetermined portion during the loading and/or unloading process are defined in the recipe, and the controlling part is adapted to forecast a temperature of the object to be processed during the loading and/or unloading process and a temperature of the predetermined portion during the loading and/or unloading process by using the outputs of the plurality of temperature sensors and the thermal model, and to control the plurality of heaters so as to cause the forecasted temperature of the object to be processed and the forecasted temperature of the predetermined portion to respectively coincide with the desired temperature of the object to be processed during the loading and/or unloading process and the desired temperature of the predetermined portion during the loading and/or unloading process defined in the recipe.

**12.** A thermal processing method of controlling a thermal processing apparatus including:

a processing container for containing an object to be processed,
a plurality of heaters for heating the object to be processed, and
a plurality of temperature sensors for respectively detecting temperatures at a plurality of predetermined positions in the processing container,
the thermal processing method comprising:
a forecasting step of forecasting a temperature of the object to be processed and a temperature of at least one other predetermined portion in the processing container by applying outputs of the plurality of temperature sensors to a thermal model that has been set in advance, and
a controlling step of controlling the plurality of heaters so as to cause the forecasted temperature of the object to be processed and the forecasted temperature of the predetermined portion to respectively coincide with a desired temperature of the object to be processed and a desired temperature of the predetermined portion that have been defined in advance.

**13.** A program for controlling a thermal processing apparatus including:

a processing container for containing an object to be processed,
a plurality of heaters for heating the object to be processed, and
a plurality of temperature sensors for respectively detecting temperatures at a plurality of predetermined positions in the processing container,
the program being adapted to cause a computer to execute the method of claim 12.

14. A storage medium capable of being read by a computer, storing a program according to claim 13.

15. A controlling unit for controlling a thermal processing apparatus including:

a processing container for containing an object to be processed,
a plurality of heaters for heating the object to be processed, and
a plurality of temperature sensors for respectively detecting temperatures at a plurality of predetermined positions in the processing container,
the controlling unit comprising:
a storing part that stores: a thermal model for forecasting a temperature of the object to be processed contained in the processing container from outputs of the plurality of temperature sensors, and a recipe in which a desired temperature of the object to be processed is defined, and
a controlling part that forecasts a temperature of the object to be processed by using the outputs of the plurality of temperature sensors and the thermal model, and that controls the plurality of heaters so as to cause the forecasted temperature of the object to be processed to coincide with the desired temperature of the object to be processed defined in the recipe,
wherein
the thermal model is configured to forecast, from the outputs of the plurality of temperature sensors, not only a temperature of the object to be processed contained in the processing container but also a temperature of at least one other predetermined portion in the processing container,
a desired temperature of the predetermined portion is also defined in the recipe, and
the controlling part is adapted to forecast a temperature of the object to be processed and a temperature of the predetermined portion by using the outputs of the plurality of temperature sensors and the thermal model, and to control the plurality of heaters so as to cause the forecasted temperature of the object to be processed and the forecasted temperature of the predetermined portion to respectively coincide with the desired temperature of the object to be processed and the desired temperature of the predetermined portion defined in the recipe.

16. A program executed by a computer system including at least a computer, in order to materialize in the computer system a controlling unit according to claim 15.

17. A program including a command for controlling a second program operable in a computer system including at least a computer,
the program being executed by the computer system to control the second program to materialize in the computer system a controlling unit according to claim 15.

18. A storage medium capable of being read by a computer, storing a program,
the program being executed by a computer system including at least a computer in order to materialize in the computer system a controlling unit according to claim 15.

19. A storage medium capable of being read by a computer, storing a program,
the program including a command for controlling a second program operable in a computer system including at least a computer,
the program being executed by the computer system to control the second program to materialize in the computer system a controlling unit according to claim 15.

## FIG. 1

FIG. 2

111

THERMAL-MODEL
STORING PART

STANDARD
THERMAL MODEL M1

CORRECTED
THERMAL MODEL M2

FIG. 3A

112

RECIPE STORING PART

SET-UP RECIPE R1

PROCESS RECIPE R2

FIG. 3B

33

P7    P6

FIG. 4

TEMPERATURE

TIME

FIG. 5

FIG. 6

FIG. 7

FIG. 8

CORRECTING OPERATION OF
STANDARD THERMAL MODEL M1
(GENERATION OF CORRECTED
THERMAL MODEL M2)

REDUCING PRESSURE IN PROCESSING CONTAINER — S11

HEATING IN ACCORDANCE WITH SET-UP RECIPE — S12

TAKING MEASURED TEMPERATURES OF
TEMPERATURE SENSORS S1 TO S5 AND
THERMOCOUPLES TC1 TO TC9 — S13

FORECASTING TEMPERATURES AT TEMPERATURE
MEASUREMENT POSITIONS P1 TO P9 AND
TEMPERATURE SENSOR S4 BY USING STANDARD
THERMAL MODEL M1 — S14

ASSOCIATING MEASURED VALUES AND FORECASTED
VALUES OF TEMPERATURES AT TEMPERATURE
MEASUREMENT POSITIONS P1 TO P9 AND
TEMPERATURE SENSOR S4 — S15

NO ◇ COMPLETION ? — S16

YES

OBTAINING CORRECTION VALUES OF TEMPERATURES
AT TEMPERATURE MEASUREMENT POSITIONS P1 TO
P9 AND TEMPERATURE SENSOR S4 — S18

CORRECTING STANDARD THERMAL MODEL M1
(GENERATING CORRECTED THERMAL MODEL M2) — S19

END

# FIG. 9

| SET (TARGET) TEMPERATURE | MEASURED TEMPERATURE | | | | | FORECASTED TEMPERATURE | | | | |
|---|---|---|---|---|---|---|---|---|---|---|
| | TC1 | TC2 | ···· | TC9 | S4 | TP1 | TP2 | ···· | TP9 | S4 |
| 500°C | 490°C | 480°C | ···· | 490°C | 480°C | 500°C | 500°C | ···· | 500°C | 500°C |
| 600°C | 587°C | 570°C | ···· | 590°C | 585°C | 600°C | 600°C | ···· | 600°C | 600°C |
| ······ | ···· | ···· | ···· | ···· | ···· | ···· | ···· | ···· | ···· | ···· |
| 1100°C | 1090°C | 1070°C | ···· | 1090°C | 1080°C | 1100°C | 1100°C | ···· | 1100°C | 1100°C |

FIG. 10

EP 1 684 336 A1

DIFFERENCE BETWEEN
FORECASTED TEMPERATURE
AND MEASURED TEMPERATURE

● : FORECASTED TEMPERATURE -
MEASURED TEMPERATURE

f (TPi)

FORECASTED TEMPERATURE TPi

FIG. 11

LOADING OPERATION

LOADING ~S21

CONTROLLING HEATERS SUCH THAT
TEMPERATURES AT SIDE WALL OF
PROCESSING CONTAINER COINCIDE
WITH TEMPERATURES DEFINED IN
PROCESS RECIPE ~S22

NO ◇ COMPLETED? ◇ S23

↓YES

END

# FIG. 12A

UNLOADING OPERATION

UNLOADING ~S25

CONTROLLING HEATERS SUCH THAT
TEMPERATURES AT SIDE WALL OF
PROCESSING CONTAINER COINCIDE
WITH TEMPERATURES DEFINED IN
PROCESS RECIPE ~S26

CONTROLLING VALVE OPENING /
CLOSING CONTROLLER 125 AND VACUUM
PUMP 126 TO DISCHARGE GAS IN
PROCESSING CONTAINER THROUGH
GAS-DISCHARGING PORTION 12 ~S27

NO ◇ COMPLETED? ◇ S28

↓YES

END

# FIG. 12B

PROCESS OPERATION

TAKING MEASURED TEMPERATURES OF TEMPERATURE SENSORS S1 TO S5 — S31

FORECASTING TEMPERATURES AT TEMPERATURE MEASUREMENT POSITIONS P1 TO P9 AND TEMPERATURE SENSOR S4 BY USING CORRECTED THERMAL MODEL — S32

CONTROLLING HEATERS 31 TO 33 SUCH THAT: FORECASTED TEMPERATURES OF POSITIONS P1 TO P5 COINCIDE WITH WAFER TEMPERATURES SPECIFIED BY PROCESS RECIPE, AVERAGE VALUE OF FORECASTED TEMPERATURES OF POSITIONS P6 AND P7 COINCIDES WITH TEMPERATURE OF LOWER HEATER SPECIFIED BY PROCESS RECIPE, AVERAGE VALUE OF FORECASTED TEMPERATURES OF POSITIONS P8 AND P9 COINCIDES WITH TEMPERATURE OF INSIDE SURFACE OF PROCESSING CONTAINER 11 SPECIFIED BY PROCESS RECIPE, AND FORECASTED TEMPERATURE OF TEMPERATURE SENSOR S4 COINCIDES WITH TEMPERATURE OF TEMPERATURE SENSOR S4 SPECIFIED BY PROCESS RECIPE — S33

CONTROLLING PRESSURE, GAS FLOW RATE, AND SO ON — S34

NO — COMPLETION? — S35

YES

END

FIG. 13

## INTERNATIONAL SEARCH REPORT

| International application No. |
|---|
| PCT/JP2004/016213 |

A. CLASSIFICATION OF SUBJECT MATTER
Int.Cl⁷ H01L21/205, H01L21/31, H01L21/324, C23C16/44, H01L21/22, H01L21/223, H01L21/225, H01L21/228

According to International Patent Classification (IPC) or to both national classification and IPC

B. FIELDS SEARCHED

Minimum documentation searched (classification system followed by classification symbols)
Int.Cl⁷ H01L21/205, H01L21/31, H01L21/324, C23C16/00-16/56, H01L21/22, H01L21/223, H01L21/225, H01L21/228

Documentation searched other than minimum documentation to the extent that such documents are included in the fields searched
| | | | |
|---|---|---|---|
| Jitsuyo Shinan Koho | 1922-1996 | Toroku Jitsuyo Shinan Koho | 1994-2005 |
| Kokai Jitsuyo Shinan Koho | 1971-2005 | Jitsuyo Shinan Toroku Koho | 1996-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 2002-091574 A (Tokyo Electron Ltd.),<br>29 March, 2002 (29.03.02),<br>Full text<br>& US 2002/0045146 A1 & EP 1189261 A2 | 1,3,8,10,<br>12-14<br>9,11,15-19 |
| A | JP 2002-043226 A (Tokyo Electron Ltd.),<br>08 February, 2002 (08.02.02),<br>Full text<br>(Family: none) | 2,4 |
| E,A | JP 2005-026397 A (Tokyo Electron Ltd.),<br>27 January, 2005 (27.01.05),<br>Full text<br>(Family: none) | 4-7 |

☐ Further documents are listed in the continuation of Box C.　　☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>01 February, 2005 (01.02.05) | Date of mailing of the international search report<br>15 February, 2005 (15.02.05) |
|---|---|
| Name and mailing address of the ISA/<br>Japanese Patent Office | Authorized officer |
| Facsimile No. | Telephone No. |

Form PCT/ISA/210 (second sheet) (January 2004)